Europäisches Patentamt

European Patent Office

Office européen des brevets

(19)

(11) Numéro de publication : **0 112 757**
**B1**

(12)

# FASCICULE DE BREVET EUROPÉEN

(45) Date de publication du fascicule du brevet :
**12.11.86**

(21) Numéro de dépôt : **83402375.6**

(22) Date de dépôt : **08.12.83**

(51) Int. Cl.⁴ : **H 01 F 40/06**, G 01 R 15/02

(54) **Pince de mesure de courant électrique à circuit magnétique à branche pivotante.**

(30) Priorité : **22.12.82 FR 8221586**

(43) Date de publication de la demande :
**04.07.84 Bulletin 84/27**

(45) Mention de la délivrance du brevet :
**12.11.86 Bulletin 86/46**

(84) Etats contractants désignés :
**CH DE GB IT LI SE**

(56) Documents cités :
**CH-A- 356 198**
**DE-C- 576 994**
**DE-C- 822 570**
**FR-A- 2 044 648**
**FR-A- 2 170 303**

(73) Titulaire : **UNIVERSAL TECHNIC**
**5, Passage Fréquel**
**F-75020 Paris (FR)**

(72) Inventeur : **Landre, Bernard**
**5, Passage Fréquel**
**F-75020 Paris (FR)**

(74) Mandataire : **Chereau, Louis et al**
**Novapat-Cabinet Chereau 107, Boulevard Péreire**
**F-75017 Paris (FR)**

Jouve, 18, rue St-Denis, 75001 Paris, France

## Description

La présente invention est du domaine des pinces de mesure de courant électrique à circuit magnétique, désignées également sous l'appellation « pinces ampèremétriques », qui permettent d'analyser ou de mesurer les caractéristiques des courants électriques circulant dans des conducteurs du type câble ou barre.

On connaît différents types de pinces de mesure de ce genre, par exemple dans le brevet FR-A-2 315 696, la demanderesse a décrit un type de pinces qui, contrairement à celles de l'art antérieur, dans lesquelles les éléments de circuits magnétiques sont limités dans leur mouvement propre à l'oscillation nécessaire à assurer une bonne portée des joints magnétiques, présente un agencement dans lequel un ou les deux éléments du circuit magnétique peuvent pendant l'opération d'enserrement du conducteur électrique prendre une infinité de positions comprises entre deux positions extrêmes pour une portion du circuit. Cet agencement à combinaisons pivotantes multiples donne à cet appareil une grande facilité pour aller enserrer des conducteurs électriques d'accès difficile ou très entouré par d'autres conducteurs, des cloisons et analogues. Toutefois, des pinces de ce type ne donnent pas toujours satisfaction du fait que lorsque la pince à articulation est mise en place autour du câble, la dimension extérieure de l'ensemble augmente, et d'autre part, lorsque la pince est mise en biais, il se produit une réaction du conducteur entouré par la pince à l'encontre de l'action du ressort, donc du sens de fermeture de la pince, ce qui ne permet pas d'assurer un excellent verrouillage (ou blocage) du circuit magnétique.

Par ailleurs on connaît des pinces dont le circuit magnétique est constitué d'une partie fixe en forme générale de U et d'une partie mobile en forme également générale de U en sens inverse dont les faces d'extrémité viennent en contact étroit sous l'action de moyens élastiques, le circuit pouvant être ouvert manuellement au moyen d'une tirette fixée sur la partie mobile de façon à permettre la pénétration latérale d'un câble à l'intérieur du circuit magnétique. Bien que ce nouveau dispositif de pince présente une certaine amélioration par rapport aux dispositifs de l'art antérieur, en se rapprochant du modèle idéal de circuit magnétique « fer à cheval-entrefer », il n'en présente pas moins certains inconvénients en particulier au niveau de la précision de guidage de la pièce mobile linéairement et du dégauchissage des surfaces extrêmes qui n'assurent généralement pas un contact suffisamment étroit des surfaces pour éviter une perte du flux magnétique.

La société déposante a également mis au point une pince de mesure de courant électrique à circuit magnétique s'ouvrant par mouvement linéaire, comportant un circuit magnétique monté sur un boîtier isolant constitué de deux éléments dont l'un est fixe tandis que l'autre est susceptible d'être déplacé selon un mouvement linéaire par rapport à l'élément fixe de façon à ouvrir le circuit latéralement, cette pince de mesure comportant des éléments constitutifs du circuit magnétique comprenant des sections obliques planes dont l'angle de pente respectif est déterminé de façon que lesdites faces planes viennent en contact étroit lors de la fermeture du circuit magnétique.

Bien que cette dernière pince présente un réel progrès par rapport aux pinces disponibles dans le commerce, elle reste relativement difficile d'utilisation lorsqu'un certain nombre de câbles dont on veut déterminer les caractéristiques électriques sont groupés en faisceaux trop serrés, ce qui rend extrêmement difficile leur engagement et leur désengagement dans l'ouverture latérale de la pince, et peut se traduire par des détériorations de la gaine de protection desdits câbles.

Une pince de mesure de courant électrique à circuit magnétique à mouvement d'ouverture combinant un mouvement linéaire et un mouvement de rotation est décrite dans le brevet FR-A-2 044 648. Cette pince comporte deux branches en forme de « L » et taillées en biseau, l'une des branches étant fixe et l'autre mobile, l'ouverture de la pince étant obtenue par un mouvement de translation de la branche mobile suivi d'un mouvement de rotation de cette même branche. L'ouverture de cette pince nécessite un mécanisme complexe dans lequel l'élément mobile est porté en bout par un mécanisme de rotation. Or, il est bien connu que le fait de monter en bout un mécanisme de rotation présente souvent des problèmes de fonctionnement et une usure beaucoup plus grande que lorsque le mécanisme est supporté par deux paliers.

La présente invention a pour but de remédier aux inconvénients précités des pinces ampèremétriques de l'art antérieur.

A cet effet, la pince de mesure de courant électrique à circuit magnétique de l'invention comprend un circuit magnétique comportant deux éléments mobiles l'un par rapport à l'autre, le mouvement relatif desdits éléments étant composé d'un mouvement de translation et d'un mouvement de rotation, les surfaces de contact desdits éléments étant constituées par des faces planes en regard, de sections obliques, et un circuit électrique entourant au moins partiellement le circuit magnétique et pouvant être raccordé à un appareil de mesure, le mouvement de translation étant obtenu par un déplacement linéaire de l'un des éléments par rapport à l'autre élément et est caractérisée en ce que le mouvement de rotation est obtenu par un pivotement du second élément autour de son axe longitudinal, ledit second élément étant monté en rotation sur le boîtier.

La pince de mesure de courant électrique à circuit magnétique s'ouvrant par une combinaison de mouvement linéaire et de mouvement rotatif selon l'invention, comporte un circuit magnétique logé dans un boîtier, et constitué de deux éléments dont l'un est susceptible d'être déplacé selon un mouvement linéaire par rapport à l'autre élément, ce second élément étant monté en rotation dans le boîtier de façon à pouvoir pivoter autour de son axe longitudinal, de façon à ouvrir frontalement le circuit, cette pince de mesure comportant en outre des éléments constitutifs du circuit magnétique comprenant des sections obliques planes dont l'angle de pente respectif est déterminé de façon que lesdites faces planes viennent en contact étroit lors de la fermeture du circuit magnétique.

Dans une forme préférée de réalisation de l'invention, les deux éléments constitutifs du circuit magnétique sont respectivement constitués de deux barres sensiblement parallèles l'une à l'autre et comportant respectivement à leurs extrémités des zones coudées se terminant par des faces planes obliques de raccordement du circuit magnétique ; l'élément mobile en rotation est monté à pivotement dans le boîtier par l'intermédiaire, d'une part, d'une bague solidaire dudit élément et formant palier avec un alésage prévu dans la face supérieure du boîtier et, d'autre part, d'un arbre s'étendant dans le prolongement de l'axe longitudinal de l'élément rotatif et monté en porte-à-faux par son extrémité libre dans la face inférieure du boîtier ; l'élément mobile en translation, se déplace de façon linéaire tout en restant sensiblement parallèle à l'élément rotatif, avec un débattement suffisant pour permettre la rotation de ce dernier ; l'élément mobile en translation se déplace avec un certain jeu latéral limité par au moins une butée de guidage à l'intérieur du boîtier ; l'élément mobile en translation est sollicité en position de fermeture du circuit magnétique par des moyens élastiques de rappel ; des moyens de manœuvre étant prévus pour exercer une force opposée à celle des moyens élastiques avec un débattement suffisant pour permettre l'ouverture du circuit et le pivotement de l'élément mobile en translation ; les moyens de réglage sont prévus pour venir, en coopération avec l'élément mobile en translation à l'intérieur du boîtier, régler le déplacement linéaire de l'élément mobile en translation ; les deux éléments constitutifs du circuit magnétique sont conformés pour recevoir un bobinage ; les moyens élastiques de rappel de l'élément mobile dans la position de fermeture du circuit magnétique sont constitués par un ressort de compression prenant appui d'une part sur la zone inférieure de l'élément mobile en translation et d'autre part sur la face inférieure du boîtier ; les moyens de manœuvre de l'élément mobile en translation sont constitués par une tirette se déplaçant dans une lumière prévue sur une face latérale du boîtier ; la section de la partie supérieure du circuit magnétique est prévue juste au niveau du coude supérieur de l'élément mobile en translation, tandis que la section de la partie inférieure du circuit magnétique est prévue juste au niveau du coude inférieur de l'élément mobile en rotation.

D'autres caractéristiques et avantages de la pince ampèremétrique à branche rotative selon l'invention apparaîtront à la lecture de la description suivante d'une forme de réalisation non limitative, en référence aux dessins annexés dans lesquels :

La figure 1   est une vue en élévation latérale de la pince ampèremétrique à branche rotative de l'invention prise du grand côté du boîtier, ce dernier étant vu partiellement en coupe, la paroi latérale du boîtier étant retirée et le circuit magnétique en position fermée ;

La figure 2   est une vue de la pince de la figure 1 prise selon la flèche II de la figure 1 ; et

La figure 3   est une vue de la pince ampèremétrique prise selon la flèche III de la figure 1, le circuit magnétique étant en position ouverte.

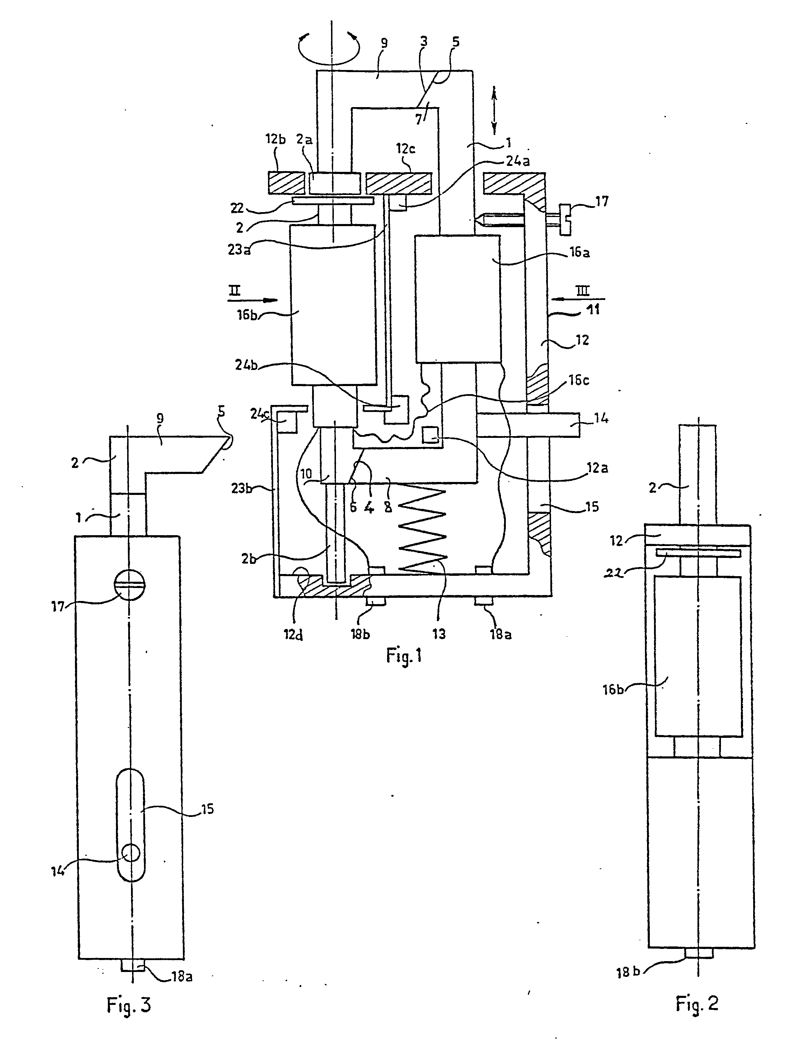

La pince ampèremétrique de l'invention comporte un circuit magnétique constitué d'un élément mobile en translation 1 monté à coulissement à l'intérieur du boîtier 12 de la pince ampèremétrique et guidé au moyen d'une entretoise ou butée de guidage 12a, et d'un élément mobile en rotation 2 monté pivotant sur le boîtier 12. Les éléments 1 et 2 ont sensiblement la même longueur sont, soit de section parallélépipédique (comme représenté), soit de révolution, et sont disposés sensiblement parallèlement l'un à l'autre. Dans les zones d'extrémité respectives des éléments 1 et 2, sont ménagées respectivement des zones coudées 7, 8, 9, 10, présentant respectivement à leurs extrémités libres des faces planes 3, 4 ; 5, 6 dirigées obliquement par rapport à la section droite des zones coudées respectives selon des angles de pente appropriés pour que lors de la fermeture du circuit magnétique comme représenté sur la figure 1, les faces obliques des zones coudées viennent en contact étroit. L'élément mobile en rotation 2 est monté sur le boîtier par l'intermédiaire d'une part d'une bague 2a qui lui est solidaire et forme palier avec un alésage prévu sur la face supérieure 12b du boîtier 12 et d'autre part d'un arbre 2b s'étendant dans le prolongement de l'axe longitudinal de l'élément 2. Cet arbre 2b est monté en porte-à-faux par son extrémité libre dans un alésage borgne ménagé dans la face inférieure interne 12d du boîtier 12. Tout déplacement longitudinal de l'élément 2 est empêché grâce à une bague d'arrêt 22.

La fermeture du circuit magnétique 1, 2 est réalisée par des moyens élastiques, par exemple un ressort de compression 13 qui sollicite l'élément mobile en translation 1 en position de fermeture en prenant appui d'une part sur la zone coudée 8 et d'autre part sur la face inférieure 12d du boîtier 12. L'ouverture du circuit magnétique est réalisée, d'une part, au moyen d'une tirette 14 solidarisée à l'élément mobile en translation 1, et pouvant se déplacer à l'encontre de l'action du ressort 13 dans une lumière 15 ménagée longitudinalement dans une paroi 11 du boîtier 12 dans laquelle coulisse l'élément 1, et d'autre part, par une rotation, possible par l'effacement de l'élément 1, de l'élément 2 d'environ 90°. Lors du mouvement de déverrouillage du circuit magnétique, le mouvement de l'élément mobile en translation 1 est limité par la lèvre inférieure de la lumière 15 contre laquelle vient buter la tirette 14, tandis que le pivotement de l'élément 2 est limité par des butées non représentées au dessin de façon que l'élément 2 puisse avoir un mouvement de ± 90° par rapport à sa position de fermeture du circuit magnétique.

Les éléments mobiles en translation 1 et mobiles en rotation 2 du circuit ampèremétrique portent chacun un bobinage, les bobinages respectifs 16a, 16b étant couplés en série, le conducteur 16c les reliant étant prévu suffisamment long pour permettre à l'élément 1 d'effectuer son mouvement coulissant à l'ouverture sans entrave ni rupture du circuit. Chaque bobinage 16a, 16b est également relié à des bornes respectives 18a, 18b prévues à la face inférieure du boîtier 12. Le bobinage 16b est protégé par un capot et sert de prise pour imprimer une rotation à l'élément mobile 2 lors de l'ouverture ou de la fermeture du circuit ampèremétrique. A cet effet, on a prévu un système de cloisonnage 23a, 23b et d'entretoises 24a, 24b, 24c, pour isoler la bobine 16b du boîtier 12.

Les faces obliques d'appui 3, 4 ; 5, 6 présentent des angles de pente relativement faibles par rapport à la section droite des zones coudées correspondantes 7, 8 ; 9, 10 de façon à obtenir une décomposition des forces de rappel des moyens élastiques 13 très favorable à l'efficacité de la fermeture du circuit magnétique.

On a également prévu des moyens de réglage 17 qui coopèrent latéralement avec l'élément mobile en translation 1, et la butée de guidage 12a à l'intérieur du boîtier, de façon à permettre un réglage ou une compensation des variations d'usinage des éléments constitutifs 1, 2 du circuit magnétique ainsi que des imperfections pouvant résulter de l'utilisation de la pince ampèremétrique au bout d'un certain temps de fonctionnement. Ces moyens de réglage sont avantageusement constitués par une vis à pointeau 17, vissée dans un trou traversant taraudé d'une paroi 11 et venant en contact avec une paroi latérale de l'élément mobile 1 de façon à orienter l'élément mobile 1 selon un trajet linéaire préférentiel permettant une mise en contact étroit des faces de jonction 3, 5 et 4, 6 du circuit magnétique.

La pince ampèremétrique de la présente invention peut être utilisée de la manière suivante : on commence par ouvrir le circuit magnétique en appliquant sur les moyens de manœuvre 14 une force sollicitant l'élément mobile en translation 1 dans la direction d'ouverture du circuit magnétique, à l'encontre des moyens élastiques 13 de rappel, en dégageant ainsi l'élément mobile en rotation 2 que l'on fait tourner de 90° environ de façon à définir une ouverture frontale dans le circuit magnétique pour le passage du conducteur traversé par un courant dont on veut déterminer les caractéristiques électriques, après quoi on ramène par rotation inverse l'élément mobile 2 dans sa position primitive et on relâche la force appliquée sur les moyens de manœuvre 14 et le circuit magnétique se referme sous l'action des moyens élastiques 13 de rappel qui sollicitent l'élément mobile en translation 1 en position de blocage dudit circuit magnétique contre l'élément mobile en rotation 2 revenu à sa position primitive. On peut alors procéder aux déterminations désirées.

Il est clair que l'encombrement extérieur réduit au minimum des éléments des branches 1, 2 du circuit magnétique permet une meilleure approche des conducteurs à mesurer, de même que le coulissement de l'élément 1 permet le pivotement de l'élément rotatif 2 en dégageant ainsi une fenêtre frontale par laquelle le conducteur peut être introduit facilement à l'intérieur du circuit magnétique qui se fermera par rotation inverse de l'élément 2 suivi de translation auto-bloquante de l'élément 1 sous l'action de moyens élastiques de rappel 13.

On comprendra aisément que la vis pointeau 17 sert d'une part de point de réaction pour appliquer les faces 3 et 4 de l'élément du circuit mobile en translation 1 contre les faces correspondantes 5 et 6 de l'élément du circuit mobile en rotation 2 sous l'effet de la décomposition de force du ressort 13 et d'autre part, du moyen de réglage de la hauteur respective de l'élément du circuit mobile en translation 1 par rapport à l'élément de circuit mobile en translation 2, l'élément mobile en translation ayant tendance à remonter plus haut lorsque la vis 17 est desserrée.

Cette disposition permet non seulement d'envoyer une bonne force d'appui des faces obliques les unes contre les autres mais également de faire exactement coïncider les faces d'appui entre elles et d'éviter ainsi les pertes de flux magnétique au niveau des faces externes des éléments du circuit magnétique. Pour des raisons de facilité d'utilisation lors de l'ouverture, on comprendra qu'il est préférable que la section du circuit magnétique dans sa branche extérieure (faces 3 et 5) doit être aussi près que possible de la partie coudée supérieure de l'élément de circuit mobile en translation, et de préférence juste au niveau du coude 7 de l'élément mobile 1, de même, pour des raisons d'encombrement au moment du pivotement de l'élément rotatif 2, la section de la partie inférieure (faces 4, 6) doit être aussi proche que possible de la partie coudée inférieure de l'élément de circuit mobile en rotation, et de préférence juste au niveau du coude 10 de l'élément 2.

## Revendications

1. Pince de mesure de courant électrique à circuit magnétique comprenant un circuit magnétique comportant deux éléments (1, 2) mobiles l'un par rapport à l'autre, le mouvement relatif desdits éléments étant composé d'un mouvement de translation et d'un mouvement de rotation, les surfaces de contact desdits éléments étant constituées par des faces planes en regard (3, 4 ; 5, 6) de sections obliques, et un circuit électrique entourant au moins partiellement le circuit magnétique et pouvant être raccordé à un appareil de mesure, le mouvement de translation étant obtenu par un déplacement linéaire de l'un des éléments (1) par rapport à l'autre élément (2), caractérisée en ce que le mouvement de rotation est obtenu par un pivotement du second élément (2) autour de son axe longitudinal, ledit second élément étant monté en rotation sur le boîtier.

2. Pince de mesure selon la revendication 1, caractérisée par le fait que les éléments (1, 2) sont constitués de deux barres sensiblement parallèles, comportant respectivement à leurs extrémités des zones coudées (7, 8 ; 9, 10) se terminant chacune par la face oblique de raccordement correspondante (3, 4 ; 5, 6) du circuit magnétique.

3. Pince de mesure selon la revendication 1, caractérisée en ce que l'élément mobile en rotation (2) est monté pivotant à l'intérieur du boîtier (12) par l'intermédiaire, d'une part, d'une bague (2a) qui est solidaire dudit élément (2) et forme palier avec un alésage prévu sur la face supérieure (12b) du boîtier (12) et, d'autre part d'un arbre (2b) s'étendant dans le prolongement de l'axe longitudinal de l'élément rotatif (2) et monté à porte-à-faux par son extrémité libre dans un alésage borgne ménagé dans la face inférieure interne (12d) du boîtier (12).

4. Pince de mesure selon la revendication 1, caractérisée par le fait que l'élément mobile en translation (1) se déplace de façon linéaire tout en restant sensiblement parallèle à l'élément fixe (2).

5. Pince de mesure selon la revendication 1, caractérisée par le fait que l'élément mobile en translation (1) se déplace, avec un certain jeu limité par des butées de guidage (12a, 12c) à l'intérieur du boîtier (12).

6. Pince de mesure selon l'une quelconque des revendications 1 à 5, caractérisée en ce que l'élément mobile en translation (1) est sollicité en position de fermeture du circuit magnétique par des moyens élastiques (13) de rappel et que des moyens de manœuvre (14) sont prévus pour exercer une force opposée à celle des moyens élastiques pour permettre l'ouverture latérale du circuit magnétique.

7. Pince de mesure selon l'une des revendications 1 à 6, caractérisée en ce que des moyens de réglage (17) sont prévus pour venir en coopération avec l'élément mobile en translation (1) à l'intérieur du boîtier (12) pour régler le déplacement linéaire de l'élément mobile (1).

8. Pince de mesure selon l'une des revendications 1 à 6, caractérisée en ce que les deux éléments (1, 2) constitutifs du circuit magnétique sont conformés pour recevoir un bobinage.

9. Pince de mesure selon la revendication 6, caractérisée par le fait que les moyens élastiques de rappel de l'élément mobile en translation (1) dans la position de fermeture du circuit magnétique sont constitués par un ressort de compression prenant appui d'une part sur la zone inférieure (8) de l'élément mobile et d'autre part sur la face inférieure du boîtier (12).

10. Pince de mesure selon l'une quelconque des revendications 2 à 10, caractérisée en ce que la section de la portée supérieure du circuit magnétique est prévue juste au niveau du coude supérieur (7) de l'élément mobile en translation (1), tandis que la section de la partie supérieure du circuit magnétique est prévue juste au niveau du coude inférieur (10) de l'élément mobile en rotation (2).

## Claims

1. A magnetic circuit clip-on instrument for measuring an electric current including a magnetic circuit having two elements (1, 2) movable in relation to one another, with the relative movement of said elements including a translating movement and a rotating movement, the contact surfaces of said elements comprising confronting plane faces (3, 4 ; 5, 6) with an oblique cross-section, and an electric circuit surrounding at least partially the magnetic circuit and being connectable to a meter, said translating movement being obtained by linearly moving one (1) of said elements in relation to the other (2), wherein said rotating movement is reached by said second element (2) pivoting around the longitudinal axle thereof, said second element (2) being rotatably mounted on the case.

2. The clip-on instrument of claim 1, wherein said elements (1, 2) include two substantially parallel bars, comprising at the ends thereof bent regions (7, 8 ; 9, 10), respectively, each ending by the corresponding oblique counecting face (3, 4 ; 5, 6) of said magnetic circuit.

3. The clip-on instrument of claim 1, wherein said rotatably movable element (2) is pivot mounted inside said case (12) through, on one hand, a ring (2a) integral with said element (2) and forming a bearing with a provided bore on the case (12) upper face (12b) and, on the other hand, a shaft (2b) extending along the continuation of the rotatably element (2) longitudinal axle and cantilever mounted by the free end thereof into a blind bore in the internal lower face (12d) of said case (12).

4. The clip-on instrument of claim 1, wherein said translating movable element (1) linearly moves while substantially remaining parallel to the stationary element (2).

5. The clip-on instrument of claim 1, wherein said translating movable element (1) moves, with some play within guiding stops (12a, 12c) limits, inside said case (12).

6. The clip-on instrument of any preceding claims 1-5, wherein said translating movable element (1) is biaised towards the magnetic circuit closing position by return spring means (13), and operating means (14) are provided with a view to exerting a force opposite to that of said spring means to allow the side opening of said magnetic circuit.

7. The clip-on instrument of any preceding claims 1-6, wherein adjusting means (17) are provided in order to cooperate with said translating movable element (1) inside the case (12) to set the linear movement of said movable element (1).

8. The clip-on instrument of any preceding claims 1-7, wherein both said elements (1, 2) constituting said magnetic circuit are shaped with a view to receiving a winding.

· 9. The clip-on instrument of claim 6, wherein said return spring means of said translating movable element (1), when in the magnetic circuit closing position, include a compression spring bearing, on one hand, on the lower region (8) of said movable element and, on the other hand, on the lower face of said case (12).

10. The clip-on instrument of any preceding claims 2-10, wherein the section of the magnetic circuit upper extent is provided up to the level of the upper elbow (7) of said translating movable element (1), while the section of the magnetic circuit lower extent is provided just at the level of the lower elbow (10) of said rotatably movable element (2).

**Patentansprüche**

1. Elektromagnetische Strommeßvorrichtung mit einem Magnetkreis, der zwei zueinander bewegliche Teile (1, 2) aufweist, wobei sich die Relativbewegung der Teile aus einer Translationsbewegung und einer Rotationsbewegung zusammensetzt und wobei die Kontaktflächen der Teile aus ebenen (3, 4 ; 5, 6), schrägen Abschnitten gegenüberliegenden Flächen bestehen und mit einem elektrischen Kreis, der wenigstens teilweise den Magnetkreis umgibt und an ein Meßgerät anschließbar ist, wobei die Translationsbewegung durch eine Linearverschiebung des einen Teils (1) bezüglich des anderen Teils (2) erhalten wird, dadurch gekennzeichnet, daß die Rotationsbewegung durch ein Verschwenken des zweiten Teils (2) um seine Längsachse erhalten wird, wobei dieses zweite Teil drehbar am Gehäuse angeordnet ist.

2. Meßvorrichtung nach Anspruch 1, dadurch gekennzeichnet, daß die Teile (1, 2) aus zwei im wesentlichen parallel zueinander angeordneten Stäben bestehen, deren Enden abgewinkelte Abschnitte (7, 8 ; 9, 10) aufweisen, deren jeder in einer entsprechenden schrägen Verbindungsfläche (3, 4 ; 5, 6) des Magnetkreises endet.

3. Meßvorrichtung nach Anspruch 1, dadurch gekennzeichnet, daß das rotationsbewegliche Teil (2) drehbar im Inneren des Gehäuses (12) mittels einerseits eines Ringes (2a) angeordnet ist, der mit dem Teil (2) fest verbunden ist und zusammen mit einer auf der Oberfläche (12b) des Gehäuses (12) vorgesehenen Bohrung ein Lager bildet und andererseits mittels einer Welle (2b), die sich in der Verlängerung der Längsachse des drehbaren Teils (2) erstreckt und deren freies Ende frei tragend in einer in der unteren Innenfläche (12d) des Gehäuses (12) vorgesehenen Blindbohrung angeordnet ist.

4. Meßvorrichtung nach Anspruch 1, dadurch gekennzeichnet, daß das translationsbewegliche Teil (1) linear verschiebbar ist und im wesentlichen parallel zum feststehenden Teil (2) verbleibt.

5. Meßvorrichtung nach Anspruch 1, dadurch gekennzeichnet, daß das translationsbewegliche Teil (1) mit einem gewissen durch im Inneren des Gehäuses (12) angeordneten Führungsanschläge (12a, 12c) begrenztes Spiel verschiebbar ist.

6. Meßvorrichtung nach einem der Ansprüche 1 bis 5, dadurch gekennzeichnet, daß das translationsbewegliche Teil (1) in Schließstellung des Magnetkreises von einer elastischen Rückholanordnung (13) beaufschlagt wird und daß eine Betätigungsanordnung (14) vorgesehen ist, um eine Kraft auszuüben, die derjenigen der elastischen Anordnung entgegengesetzt ist um die seitliche Öffnung des Magnetkreises zu ermöglichen.

7. Meßvorrichtung nach einem der Ansprüche 1 bis 6, dadurch gekennzeichnet, daß eine Regelanordnung (17) vorgesehen ist, die mit dem translationsbeweglichen Teil im Inneren des Gehäuses (12) zusammenwirkt um die lineare Verschiebung des beweglichen Teils (1) zu steuern.

8. Meßvorrichtung nach einem der Ansprüche 1 bis 6, dadurch gekennzeichnet, daß die beiden den Magnetkreis bildenden Teile (1, 2) so gestaltet sind, daß sie eine Wicklung aufnehmen können.

9. Meßvorrichtung nach Anspruch 6, dadurch gekennzeichnet, daß die elastische Rückholanordnung für das translationsbewegliche Teil (1) in der Schließstellung des Magnetkreises aus einer Druckfeder besteht, die sich einerseits auf dem unteren Abschnitt (8) des beweglichen Teils abstützt und andererseits auf der Innenfläche des Gehäuses (12).

10. Meßvorrichtung nach einem der Ansprüche 2 bis 9, dadurch gekennzeichnet, daß der Abschnitt des oberen Jochs des Magnetkreises bis zur Höhe der oberen Abschrägung (7) des translationsbeweglichen Teils (1) reicht, während der Abschnitt der unteren Teils des Magnetkreises gerade bis auf Höhe der unteren Abschrägung (10) des rotationsbeweglichen Teils (2) reicht.

**0 112 757**

Fig. 1

Fig. 3

Fig. 2

1